# EUROPEAN PATENT APPLICATION

(11) **EP 4 216 434 A1**
(43) Date of publication of application: **26.07.2023**
(21) Application number: 23151049.6
(22) Date of filing: 11.01.2023
(51) Int. Cl.: H03H 3/04, H03H 9/02

(54) **BULK ACOUSTIC WAVE RESONATORS WITH TUNABLE ELECTROMECHANICAL COUPLING**

(30) Priority: 11.01.2022 US 202263298244 P; 29.03.2022 US 202263324946 P; 05.01.2023 US 202318150614
(71) Applicant: Qorvo US, Inc., Greensboro, NC 27409 (US)
(72) Inventor: KOOHI, Milad Zolfagharloo, Apopka 32703 (US); FATTINGER, Gernot, Apopka 32703 (US); ALJOUMAYLY, Mudar, Apopka 32703 (US); SADHU, Jyothi, Apopka 32703 (US)
(74) Representative: D Young & Co LLP

(57) **Abstract**

The present disclosure relates to a Bulk Acoustic Wave, BAW, resonator with tunable electromechanical coupling. The disclosed BAW resonator (30) includes a bottom electrode (32), a top electrode (34), and a multilayer transduction structure (36) sandwiched therebetween. Herein, the multilayer transduction structure is composed of multiple transduction layers (38_1, .... 38_N), and at least one of the transduction layers is formed of a ferroelectric material, whose polarization will vary with an electric field across the ferroelectric material. Upon adjusting direct current , DC, bias voltage across the bottom electrode (32) and the top electrode (34), an overall polarization of the multilayer transduction structure (36) and an overall electromechanical coupling coefficient of the multilayer transduction structure are capable of being changed. Once the change of the overall electromechanical coupling coefficient of the multilayer transduction structure is completed, the overall electromechanical coupling coefficient of the multilayer transduction structure will remain unchanged after removing the DC bias voltage.

## Description

### Related Applications

This application claims the benefit of provisional patent application serial number 63/298,244 filed January 11, 2022, and provisional patent application serial number 63/324,946, filed March 29, 2022, the disclosures of which are hereby incorporated herein by reference in their entireties.

### Field of the Disclosure

The present disclosure relates to a Bulk Acoustic Wave (BAW) resonator, which uses multilayer transduction materials, with tunable electromechanical coupling.

### Background

Due to their small size, high Q values, and very low insertion losses at microwave frequencies, particularly those above 1.5 Gigahertz (GHz), Bulk Acoustic Wave (BAW) filters have been widely used in many modern wireless applications. For instance, the BAW filters incorporating BAW resonators are the filter of choice for many 3^{rd} Generation (3G) and 4^{th} Generation (4G) wireless devices, and are destined to dominate filter applications for 5^{th} Generation (5G) wireless devices.

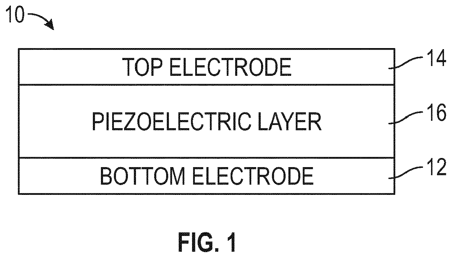

One example of a conventional BAW resonator 10 is illustrated in Figure 1. The BAW resonator 10 includes a bottom electrode 12, a top electrode 16, and a piezoelectric layer 16 (which is sometimes referred to as a transduction layer) sandwiched between the bottom electrode 12 and the top electrode 14. Typically, the electrical properties of the conventional piezoelectric BAW resonator 10, including electromechanical coupling coefficient *Kₑ*², are not reconfigurable. However, for designing low loss BAW filters with steep slopes, BAW resonators with different electromechanical coupling coefficients *Kₑ²* are required. It is challenging to fabricate resonators with different electromechanical coupling coefficients *Kₑ²* on the same die. Therefore, external components like capacitors and inductors are used to adjust the electromechanical coupling coefficient *Kₑ²* of the BAW resonators, which makes the filter modules bulky, costly, and complex.

As an existing solution to this challenge, the BAW resonator with a voltage tunable *Kₑ²* was proposed based on a barium strontium titanate transduction layer being used in its "paraelectric" phase instead of the conventional piezoelectric transduction layer. A drawback of using a transduction material in its paraelectric phase is the necessity of a continuous direct current (DC) bias voltage applied across the electrodes of the device in an "on state" operation ("on state": when the device acts as a resonator; "off state": when no DC bias voltage is applied and the device acts as a simple capacitor). The continuous DC bias voltage across the resonator will cause a continuous leakage current through the resonator, and thus a continuous electric power loss.

### Summary

Particular aspects are set out in the appended independent claims. Various optional embodiments are set out in the dependent claims.

Some approaches described herein may seek to provide BAW resonator designs to achieve tunable electromechanical coupling coefficients *Kₑ²* without suffering continuous electric power loss and a bulk volume of the final product. Further, some approaches described herein may seek to keep the final product easy to implement and cost effective

The present disclosure relates to a Bulk Acoustic Wave (BAW) resonator with tunable electromechanical coupling. The disclosed BAW resonator includes a bottom electrode, a top electrode, and a multilayer transduction structure sandwiched therebetween. Herein, the multilayer transduction structure is composed of multiple transduction layers, and at least one of the transduction layers is formed of a first ferroelectric material, whose polarization will vary with an electric field across the first ferroelectric material. Upon adjusting a direct current (DC) bias voltage between the bottom electrode and the top electrode, an overall polarization of the multilayer transduction structure and an overall electromechanical coupling coefficient of the multilayer transduction structure are capable of being changed. Once the change of the overall electromechanical coupling coefficient of the multilayer transduction structure is completed, the overall electromechanical coupling coefficient of the multilayer transduction structure will remain unchanged after removing the DC bias voltage.

In one embodiment of the disclosed BAW resonator, the first ferroelectric material used to form the at least one of the transduction layers has a box-shaped polarization-electric field (P-E) curve.

In one embodiment of the disclosed BAW resonator, the first ferroelectric material is scandium aluminum nitride (ScₓAl₁₋ₓN) and the P-E curve of ScₓAl₁₋ₓN is dependent on a scandium concentration x.

In one embodiment of the disclosed BAW resonator, at least one of the plurality of transduction layers is formed of a second ferroelectric material, which has a different P-E curve compared to the first ferroelectric material. In addition, at least one of the transduction layers is formed of a piezoelectric material, whose polarization does not vary with an electric field across the piezoelectric material.

In one embodiment of the disclosed BAW resonator, each of the transduction layers is formed of a different ferroelectric material.

In one embodiment of the disclosed BAW resonator, at least one of the transduction layers is formed of a piezoelectric material, whose polarization does not vary with an electric field across the piezoelectric material.

In one embodiment of the disclosed BAW resonator, each of the transduction layers has a different thickness.

In one embodiment of the disclosed BAW resonator, each of the transduction layers has a same thickness.

According to one embodiment, the disclosed BAW resonator further includes a bottom Brag reflector formed underneath the bottom electrode and a top Brag reflector formed over the top electrode.

In one embodiment of the disclosed BAW resonator, the multilayer transduction structure further includes a number of internal electrodes, which are alternated with the transduction layers. In addition, each transduction layer is formed of a different ferroelectric material.

According to an example process of forming a BAW resonator with tunable electromechanical coupling, the process includes forming a bottom electrode, forming a multilayer transduction structure over the bottom electrode, and forming a top electrode over the multilayer transduction structure. As such, the multilayer transduction structure is sandwiched between the bottom electrode and the top electrode. Herein, the multilayer transduction structure is composed of multiple transduction layers, and at least one of the transduction layers is formed of a ferroelectric material, whose polarization will vary with an electric field across the ferroelectric material. Upon adjusting a DC bias voltage between the bottom electrode and the top electrode, an overall polarization of the multilayer transduction structure and an overall electromechanical coupling coefficient of the multilayer transduction structure are capable of being changed.

According to one embodiment, the process further includes applying a DC bias voltage across the bottom electrode and the top electrode to change the overall polarization of the multilayer transduction structure and the overall electromechanical coupling coefficient of the multilayer transduction structure. Herein, once the change of the overall electromechanical coupling coefficient of the multilayer transduction structure is completed, the overall electromechanical coupling coefficient of the multilayer transduction structure will remain unchanged after removing the DC bias voltage.

In one embodiment of the process, the first ferroelectric material used to form the at least one of the transduction layers has a box-shaped P-E curve.

In one embodiment of the process, the first ferroelectric material is ScₓAl₁₋ₓN and the P-E curve of ScₓAl₁₋ₓN is dependent on a scandium concentration x.

In one embodiment of the process, at least one of the transduction layers is formed of a second ferroelectric material, which has a different P-E curve compared to the first ferroelectric material.

In one embodiment of the process, each transduction layer is formed of a different ferroelectric material.

In one embodiment of the process, at least one of the transduction layers is formed of a piezoelectric material, whose polarization does not vary with an electric field across the piezoelectric material.

According to an example system with at least one BAW resonator with tunable electromechanical coupling, the system includes a radio-frequency (RF) input circuitry, a RF output circuitry, and a filter circuitry that includes the at least one BAW resonator. Herein, the filter circuitry is connected between the RF input circuitry and the RF output circuitry. The at least one BAW resonator includes a bottom electrode, a top electrode, and a multilayer transduction structure sandwiched between the bottom electrode and the top electrode. The multilayer transduction structure is composed of multiple transduction layers, and at least one of the transduction layers is formed of a ferroelectric material, whose polarization will vary with an electric field across the ferroelectric material. Upon adjusting a DC bias voltage between the bottom electrode and the top electrode, an overall polarization of the multilayer transduction structure and an overall electromechanical coupling coefficient of the multilayer transduction structure are capable of being changed.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of various illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 illustrates a cross-section view of a conventional Bulk Acoustic Wave (BAW) resonator.
Figure 2A illustrates an example polarization-electric field (P-E) curve of one ferroelectric material.
Figure 2B illustrates example different P-E curves of ferroelectric scandium aluminum nitride (ScAlN) dependency on scandium concentration.
Figure 3 illustrates an example BAW resonator, which is capable of achieving tunable electromechanical coupling according to some embodiments of the present disclosure.
Figures 4A-4D illustrate different states of the example BAW resonator shown in Figure 3 upon applying different DC bias voltages.
Figures 5-7 illustrate an alternative BAW resonator according to some embodiments of the present disclosure.
Figure 8 illustrates a flowchart of a method of providing the BAW resonator shown in Figure 4A.
Figure 9 illustrates a block diagram of an example system that includes at least one BAW filter which is implemented by one or more BAW resonators.
Figure 10 illustrates a block diagram of example user elements that include at least one BAW filter which is implemented by one or more BAW resonators.

It will be understood that for clear illustrations, Figures 1-10 may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

An electromechanical coupling coefficient *Kₑ²* of a Bulk Acoustic Wave (BAW) resonator, such as a thin film bulk acoustic resonator (FBAR) or a solidly mounted resonator (SMR), is a function of a piezoelectric coefficient *d* of a transduction layer of the BAW resonator, and the piezoelectric coefficient *d* is proportional to a polarization *P* of the transduction layer of the BAW resonator. Therefore, once the polarization *P* of the transduction layer varies, the piezoelectric coefficient *d* will change accordingly, and consequently, the electromechanical coupling coefficient *Kₑ²* of the BAW resonator will change as well.

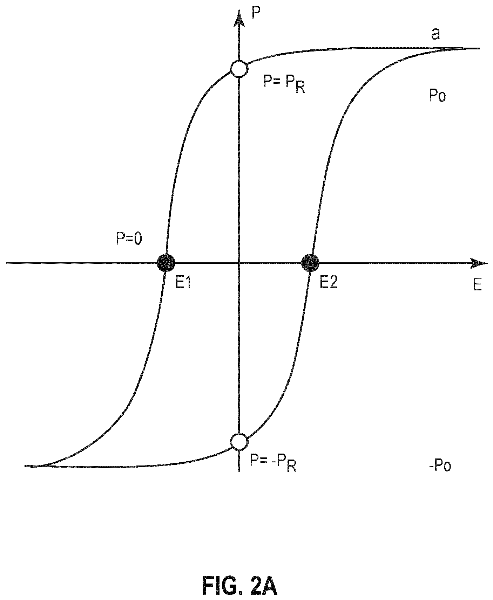

Figure 2A illustrates a simplified polarization-electric field (P-E) curve (i.e., hysteresis loop) of a ferroelectric material (herein, e.g., scandium aluminum nitride). It is clear that the polarization *P* of the ferroelectric material may be adjusted by changing the electric field *E* across the ferroelectric material. A variation amount of the polarization *P* is determined according to a variation amount of the electric field across the ferroelectric material. Herein, changing the electric field across the ferroelectric material may be implemented by applying different direct current (DC) bias voltages to the ferroelectric material. By applying a particular DC bias voltage to the ferroelectric material, the polarization *P* of the ferroelectric material can achieve a particular value. Each DC bias voltage corresponds to one polarization, depending on a previously applied electric field (i.e., previously applied DC bias voltage). For instance (e.g., moving in a counterclockwise direction), changing the electric field across the ferroelectric material from 0 to E1(i.e., by applying a particular DC bias voltage to the ferroelectric material), the polarization *P* of the ferroelectric material can be moved from *P*=*P_{R}* to *P*=*0.* As such, the piezoelectric coefficient *d* of the ferroelectric material can be zero, and the electromechanical coupling coefficient *Kₑ²* of the BAW resonator that utilizes the ferroelectric material in the transduction layer can be zero. In another instance (e.g., moving in a counterclockwise direction), changing the electric field across the ferroelectric material from E1 to 0, the polarization *P* of the ferroelectric material can be moved from *P*=*0* to *P*=*-P_{R}.*

Notice that, once the polarization *P* of the ferroelectric material achieves a desired value (i.e., the electromechanical coupling coefficient *Kₑ²* achieves a desired value), there is no need to retain the DC bias voltage applied to the ferroelectric material. After removing the DC bias voltage, the polarization *P* of the ferroelectric material (i.e., the electromechanical coupling coefficient *Kₑ²* of the ferroelectric material) will remain at that desired value, until another DC bias voltage is applied to the ferroelectric material.

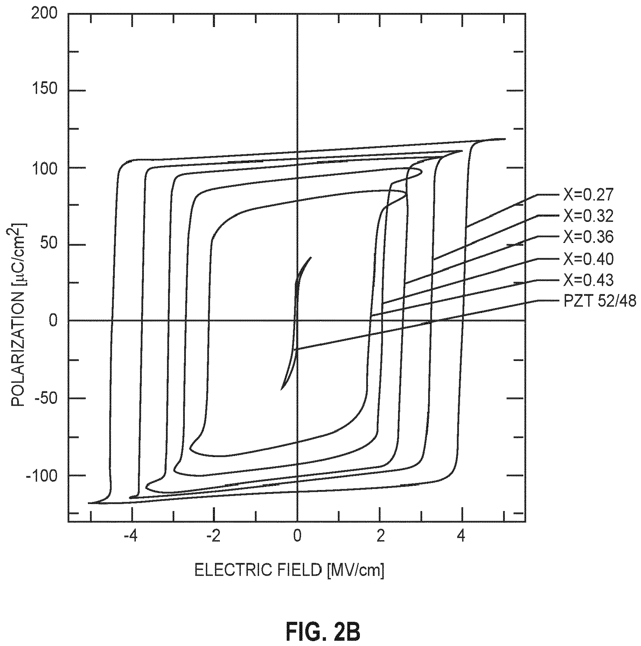

Scandium aluminum nitride (ScₓAl₁₋ₓN) is an example ferroelectric material. Figure 2B illustrates example different P-E curves of ScₓAl₁₋ₓN dependent on a scandium concentration *x.* When the scandium concentration x=0.27, the electric field E across ScₓAl₁₋ₓN requires -4.5/4 MV/cm to achieve the polarization *P* of ScₓAl₁₋ₓN equal to zero; when the scandium concentration x=0.32, the electric field E across ScₓAl₁₋ₓN requires -3.8/3.3 MV/cm to achieve the polarization *P* of ScₓAl₁₋ₓN equal to zero; when the scandium concentration x=0.36, the electric field E across ScₓAl₁₋ₓN requires -3/2.5 MV/cm to achieve the polarization *P* of ScₓAl₁₋ₓN equal to zero; when the scandium concentration x=0.40, the electric field E across ScₓAl₁₋ₓN requires -2.6/2.1 MV/cm to achieve the polarization *P* of ScₓAl₁₋ₓN equal to zero; and when the scandium concentration x=0.43, the electric field E across ScₓAl₁₋ₓN requires -2.1/1.8 MV/cm to achieve the polarization *P* of ScₓAl₁₋ₓN equal to zero (moving in a counterclockwise direction in the P-E curves). These electric field E values can change and depend on the deposition condition of the ferroelectric material (e.g., ScₓAl₁₋ₓN).

With a same electric field E (applying a same DC bias voltage), the polarization P of ScₓAl₁₋ₓN may have different values and/or different directions due to the scandium concentration x. For instance, when the electric filed E is -1.5 MV/cm, the polarization P of Sc_{0.27}Al_{0.73}N is 105 µC/cm², while the polarization P of Sc_{0.43}Al_{0.57}N is 70 µC/cm². As such, the electromechanical coupling coefficient *Kₑ²* of the ferroelectric material, which is dependent on the polarization *P* of ferroelectric material, may also have different values due to the scandium concentration x.

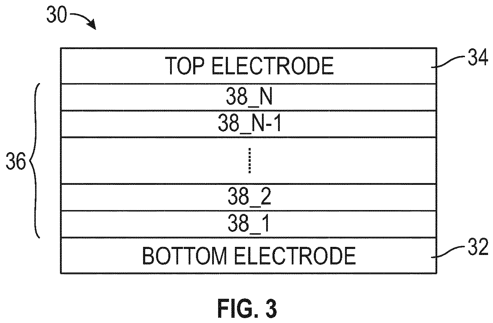

Figure 3 illustrates an example BAW resonator 30, which is capable of achieving tunable electromechanical coupling according to some embodiments of the present disclosure. The example BAW resonator 30 includes a bottom electrode 32, a top electrode 34, and a multilayer transduction structure 36 sandwiched between the bottom electrode 32 and the top electrode 34.

In detail, the bottom electrode 32 may be composed of one or more electrode layers (not shown) and includes at least one metal or alloy, such as Tungsten, Aluminum Copper, and the like. The top electrode 34 may be composed of one or more electrode layers (not shown) and includes at least one metal or alloy, such as Tungsten, Aluminum Copper, and the like. The bottom electrode 32 and the top electrode 34 each has a thickness depending on the main resonant frequency of the example BAW resonator 30. In some applications, the BAW resonator 30 may further include a recessed and/or raised border ring around the periphery of the top electrode 34 to confine the energy inside the example BAW resonator 30 and to prevent laterally propagating standing waves (not shown).

The multilayer transduction structure 36 includes multiple transduction layers 38 (e.g., as shown in Figure 3, a first transduction layer 38_1 over the bottom electrode 32, a second transduction layer 38_2 over the first transduction layer 38_1, ..... a (N-1)th transduction layer 38_N-1 over the second transduction layer 38_2, a Nth transduction layer 38_N over the (N-1)th transduction layer 38_N-1, and the top electrode 34 over the Nth transduction layer 38_N). In some cases, the multilayer transduction structure 36 may only include two transduction layers 38 (i.e., the (N-1)th transduction layer 38_N-1 and the Nth transduction layer 38_N are omitted, and the top electrode 34 is over the second transduction layer 38_2). In some cases, the multilayer transduction structure 36 may only include three transduction layers 38 (i.e., N=3, and the (N-1)th transduction layer 38_N-1 and the second transduction layer 38_2 represent a same layer).

Each transduction layer 38 may have a same or different thickness. At least one of the transduction layers 38 is formed of a ferroelectric material, whose polarization will vary with an electric field across the ferroelectric material. For instance, the ferroelectric material used for the at least one of the transduction layers 38 has a box-shaped P-E curve (e.g., as shown in Figure 2A), such as ScₓAl₁₋ₓN, Lead Zirconate Titanate (PZT), Lead titanate (PTO), Barium Titanate (BTO), Hafnium Oxide (HfO₂) or the like. As such, once the electric field across the multilayer transduction structure 36 changes, the polarization of the at least one transduction layer 38 will change accordingly, and an overall electromechanical coupling coefficient *Kₑ²* of the entire multilayer transduction structure 36 will change.

In one embodiment, some of the transduction layers 38 may be formed of a piezoelectric material (e.g., Aluminum nitride (AlN), Lithium niobate (LiNbO₃), or Zinc oxide (ZnO)), whose polarization will not vary with an electric field across the piezoelectric material; while the remaining transduction layers 38 may be formed of a ferroelectric material (e.g., ScAlN, PZT, PTO, BTO, or HfO₂), whose polarization will vary with an electric field across the ferroelectric material. Herein, by adjusting the electric field across the multilayer transduction structure 36, the polarization of the transduction layers 38 formed of the ferroelectric material may be converted to an opposite direction compared to the polarization of the transduction layers 38 formed of the piezoelectric material, or may be converted to a zero polarization. As such, an overall polarization of the multilayer transduction structure 36 may change, and consequently, the overall electromechanical coupling coefficient *Kₑ²* of the entire multilayer transduction structure 36 may change. In one embodiment, the transduction layers 38 formed of the piezoelectric material (e.g., the first transduction layer 38_1...., and the (N-1)th transduction layer 38_N-1) may be alternated with the transduction layers 38 formed of the ferroelectric material (e.g., the second transduction layer 38_2...., and the Nth transduction layer 38_N). In one embodiment, the transduction layers 38 formed of the piezoelectric material may be located in a top region of the multilayer transduction structure 36 (e.g., the Nth transduction layer 38_N and the (N-1)th transduction layer 38_N-1) and the transduction layers 38 formed of the ferroelectric material may be located in a bottom region of the multilayer transduction structure 36 (e.g., the first transduction layer 38_1 and the second transduction layer 38_2). In one embodiment, the transduction layers 38 formed of the piezoelectric material may be located in the bottom region of the multilayer transduction structure 36 (e.g., the first transduction layer 38_1 and the second transduction layer 38_2) and the transduction layers 38 formed of the ferroelectric material may be located in the top region of the multilayer transduction structure 36 (e.g., the Nth transduction layer 38_N and the (N-1)th transduction layer 38_N-1). In one embodiment, the transduction layers 38 formed of the piezoelectric material and the transduction layers 38 formed of the ferroelectric material may be positioned arbitrarily within the multilayer transduction structure 36. The number of the transduction layers 38 formed of the piezoelectric material and the number of the transduction layers 38 formed of the ferroelectric material may be different or the same.

In one embodiment, the transduction layers 38 in the multilayer transduction structure 36 may be formed of two or more ferroelectric materials, which have different P-E curves. When applying a same electric field, a polarization of each different ferroelectric material will have different values and/or directions. Therefore, by changing electric fields, the overall polarization of the multilayer transduction structure 36 may change, and consequently, the overall electromechanical coupling coefficient *Kₑ²* of the entire multilayer transduction structure 36 may change. In a simplified instance, some of the transduction layers 38 may be formed of a first ferroelectric material (e.g., ScₓAl₁₋ₓN), and some of the transduction layers 38 may be formed of a second ferroelectric material (e.g., Sc_{y}Al_{1-y}N, wherein x is different from y and each of x and y is between 0.1 and 0.8). The first ferroelectric material and the second ferroelectric material have different P-E curves. In one embodiment, upon applying a first electric field, the first ferroelectric material may have a polarization with an opposite direction to the polarization of the second ferroelectric material. Upon applying a second electric field, the polarization of the first ferroelectric material and the polarization of the second ferroelectric material have a same direction. As such, the overall polarization of the multilayer transduction structure 36 is different with the first or second electric field, and consequently, the overall electromechanical coupling coefficient *Kₑ²* of the entire multilayer transduction structure 36 is different with the first or second electric field. In one embodiment, the transduction layers 38 formed of different ferroelectric materials may be positioned alternatively. In one embodiment, the transduction layers 38 formed of different ferroelectric materials may be positioned in groups, wherein each group utilizes one ferroelectric material. In one embodiment, the transduction layers 38 formed of formed of different ferroelectric materials may be positioned arbitrarily within the multilayer transduction structure 36. The number of the transduction layers 38 formed of each ferroelectric material may be different or the same.

In one embodiment, some of the transduction layers 38 may be formed of one or more piezoelectric materials (e.g., AlN, LiNbO₃, and/or ZnO), while the remaining transduction layers 38 may be formed of two or more ferroelectric materials (e.g., ScAlN, PZT, BTO, HfO₂, and/or PTO), wherein each ferroelectric material has a different P-E curve. In a simplified instance, some of the transduction layers 38 may be formed of a piezoelectric material, some of the transduction layers 38 may be formed of a first ferroelectric material, and some of the transduction layers 38 may be formed of a second ferroelectric material. The first ferroelectric material and the second ferroelectric material have different P-E curves. In one embodiment, upon applying a first electric field, the first ferroelectric material may have a polarization with an opposite direction to the polarization of the piezoelectric material, while the second ferroelectric material may have a polarization with a same direction as the polarization of the piezoelectric material or may have a zero polarization. Upon applying a second electric field, the first ferroelectric material and the second ferroelectric material each may have a polarization with an opposite direction to the polarization of the piezoelectric material. As such, the overall polarization of the multilayer transduction structure 36 is different with the different electric field, and consequently, the overall electromechanical coupling coefficient *Kₑ²* of the entire multilayer transduction structure 36 is different with the different electric field. In one embodiment, the transduction layers 38 formed of different materials may be positioned in an alternative configuration, a grouped configuration, or an arbitrary configuration. The number of the transduction layers 38 formed of each material may be different or the same.

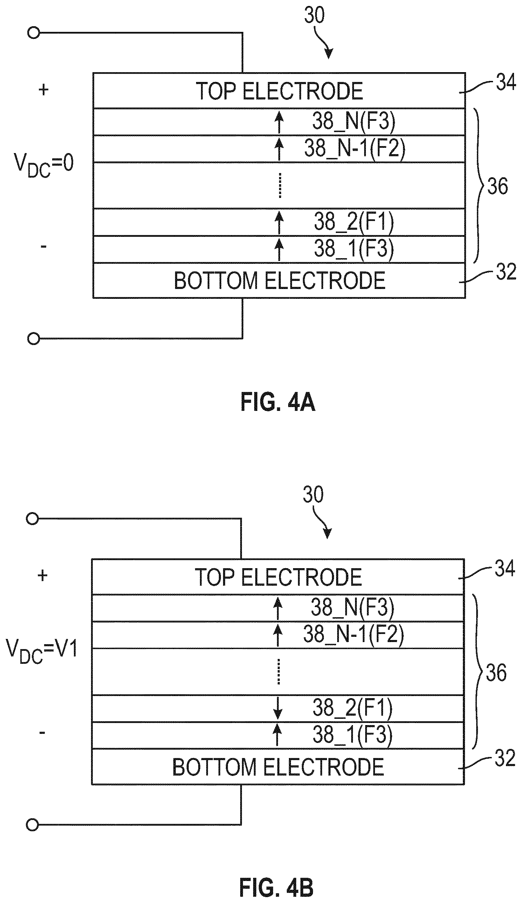

Figures 4A-4D illustrate different states of the example BAW resonator 30 shown in Figure 3 upon applying different DC bias voltages. In this example, the transduction layers 38 in the multilayer transduction structure 36 may be formed of three different ferroelectric materials (e.g., the second transduction layer 38_2 is formed of a first ferroelectric material F1, the (N-1)th transduction layer 38_N-2 is formed of a second ferroelectric material F2, and the first and the Nth transduction layers 38_1 and 38_N are formed of a third ferroelectric material F3), which have different P-E curves. Upon applying a same DC bias voltage, the first, second and third ferroelectric materials may have different polarizations. In different applications, the transduction layers 38 in the multilayer transduction structure 36 may be formed of fewer or more different ferroelectric materials in a different configuration. Optionally, some of the transduction layers 38 may be formed of one or more piezoelectric materials.

Figure 4A illustrates an initial state of the example BAW resonator 30 when no DC bias voltage (i.e., V_{DC}=0) is applied across the multilayer transduction structure 36. In the initial state, each transduction layer 38 has a same direction polarization (e.g., positive polarization, represented by upward arrows).

Figure 4B illustrates a first state of the example BAW resonator 30 when a first DC bias voltage V1 (corresponding to a first electric filed) is applied across the multilayer transduction structure 36. In the first state, the polarization of the second transduction layer 38_2 that is formed of the first ferroelectric material F1 is reversed (e.g., converted from positive to negative, represented by a downward arrow) due to the first DC bias voltage V1, while the polarizations of the remaining transduction layers 38 (e.g., the (N-1)th transduction layer 38_N-1 formed of the second ferroelectric material F2, and the first and Nth transduction layers 38_1 and 38_N formed of the third ferroelectric material F3) keep the same direction (e.g., positive, represented by the upward arrows). Therefore, the overall polarization of the multilayer transduction structure 36 and thus the overall electromechanical coupling coefficients *Kₑ²* of the multilayer transduction structure 36 changes in the first state compared to the initial state.

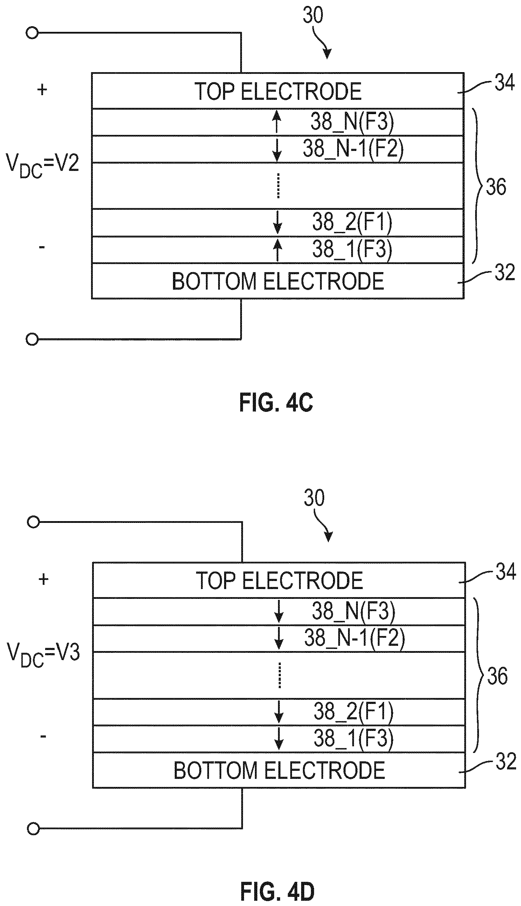

Figure 4C illustrates a second state of the example BAW resonator 30 when a second DC bias voltage V2 (corresponding to a second electric filed) is applied across the multilayer transduction structure 36. In the second state, the second DC bias voltage V2 is large enough that the polarization of the second transduction layer 38_2 formed of the first ferroelectric material F1 and the polarization of the (N-1)th transduction layer 38_N-1 formed of the second ferroelectric material F2 are both reversed (e.g., converted from positive to negative, represented by downward arrows). The polarizations of the remaining transduction layers 38 (e.g., the first and Nth transduction layers 38_1 and 38_N formed of the third ferroelectric material F3) keep the same direction (e.g., positive, represented by the upward arrows). Therefore, the overall polarization of the multilayer transduction structure 36 and thus the overall electromechanical coupling coefficients *Kₑ²* of the multilayer transduction structure 36 changes in the second state compared to the initial/first state.

Figure 4D illustrates a third state of the example BAW resonator 30 when a third DC bias voltage V3 (corresponding to a third electric filed) is applied across the multilayer transduction structure 36. In the third state, the third DC bias voltage V3 may be larger than the second bias voltage V2, and makes the polarization of each transduction layer 38 formed of the first, second, or third ferroelectric material F1/F2/F3 reversed (e.g., converted from positive to negative, represented by the downward arrows). None of the transduction layers 38 keep the original polarization direction. Therefore, the overall polarization of the multilayer transduction structure 36 and thus the overall electromechanical coupling coefficients *Kₑ²* of the multilayer transduction structure 36 changes in the third state compared to the initial/first/second state.

By adjusting the DC bias voltage between the top and bottom electrodes 32 and 34, different electric fields may be achieved across the multilayer transduction structure 36, thereby changing the overall polarization of the multilayer transduction structure 36. Therefore, the electromechanical coupling coefficients *Kₑ²* of the multilayer transduction structure 36, which is a function of the polarization of the multilayer transduction structure 36, is tunable. In different states, the multilayer transduction structure 36 has different values of the electromechanical coupling coefficients *Kₑ²*. Notice that, once the polarization of the multilayer transduction structure 36 achieves a desired value (i.e., the electromechanical coupling coefficient *Kₑ²* achieves a desired value), there is no need to retain the DC bias voltage applied to the top and bottom electrodes 32 and 34. After removing the DC bias voltage, the polarization of the multilayer transduction structure 36 (i.e., the electromechanical coupling coefficient *Kₑ²* of the multilayer transduction structure 36) will remain at that desired value, until another DC bias voltage is applied to the multilayer transduction structure 36. As such, no continuous DC bias voltage across the example BAW resonator 30 is needed. A continuous leakage current through the resonator and a continuous electric power loss, which are caused by the continuous DC bias voltage, will not exist in the example BAW resonator 30.

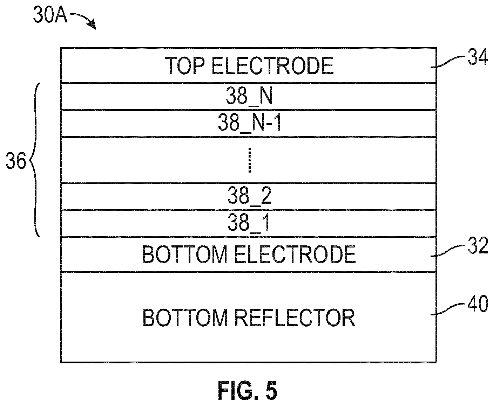

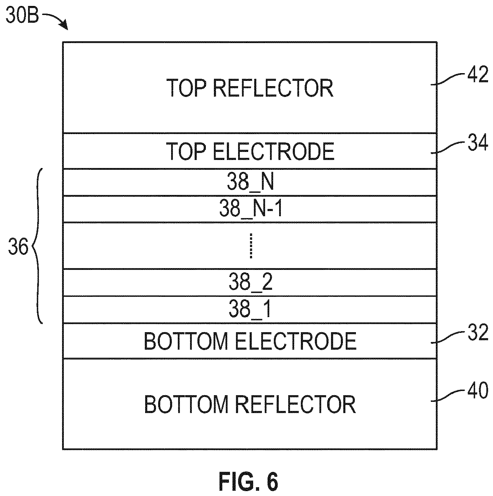

In some applications, a BAW resonator may further include one or two reflectors. Figure 5 illustrates a first alternative BAW resonator 30A, wherein in addition to the bottom electrode 32, the top electrode 34, and the multilayer transduction structure 36, the first alternative BAW resonator 30A also includes a bottom reflector 40 underneath the bottom electrode 32. The bottom reflector 40 may be a Brag reflector. As illustrated in Figure 6, a second alternative BAW resonator 30B, in addition to the bottom electrode 32, the top electrode 34, and the multilayer transduction structure 36, also includes the bottom reflector 40 underneath the bottom electrode 32 and a top reflector 42 over the top electrode 34. The bottom reflector 40 and the top reflector 42 may be Brag reflectors.

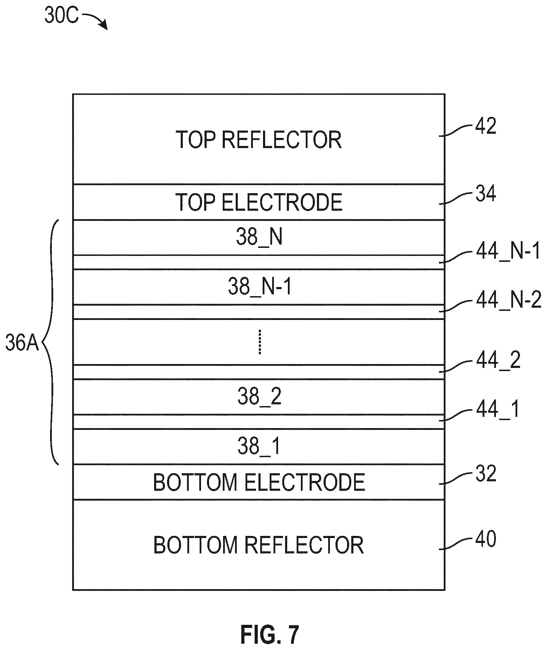

In some applications, in order to adjust the electric field across each transduction layer, internal electrodes may be used. As illustrated in Figure 7, a third alternative BAW resonator 30C includes an alternative multilayer transduction structure 36A between the bottom electrode 32 and the top electrode 34. Herein, the alternative multilayer transduction structure 36A, in addition to the multiple transduction layers 38, also includes multiple internal electrodes 44, which are alternated with the transduction layers 38 (e.g., a first internal electrode 44_1 is over the first transduction layer 38_1, the second transduction layer 38_2 is over the first internal electrode 44_1, a second internal electrode 44_2 is over the second transduction layer 38_2,..... the (N-1)th transduction layer 38_N-1 is over a (N-2)th internal electrode 44_N-2, a (N-1)th internal electrode 44_N-1 is over the (N-1)th transduction layer 38_N-1, and the Nth transduction layer 38_N is over the (N-1)th internal electrode 44_N-1). Each internal electrode 44 may be composed of one or more electrode layers (not shown) and includes at least one metal or alloy, such as Tungsten, Aluminum Copper, and the like. In one embodiment, the third alternative BAW resonator 30C may further include the bottom reflector 40 and/or the top reflector 42.

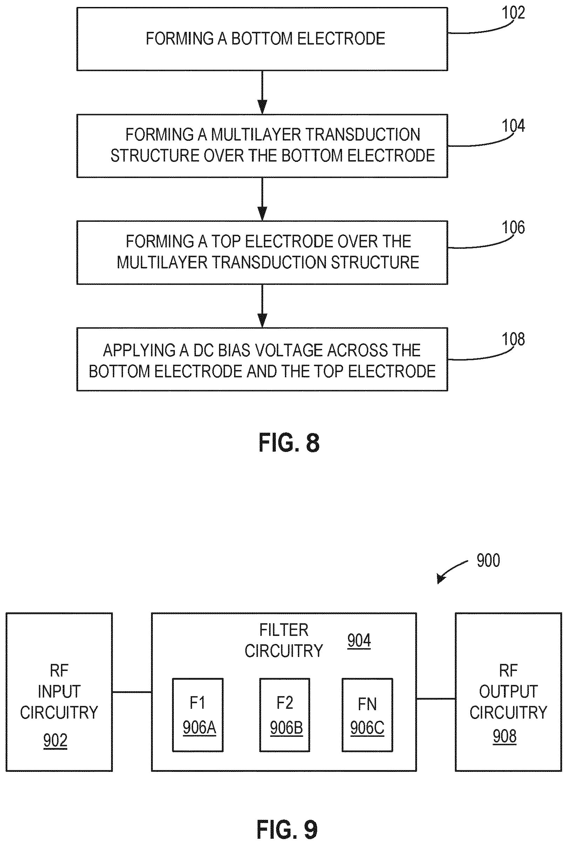

Figure 8 illustrates a flowchart of a method of providing the BAW resonator 30 shown in Figure 4A. Although the process steps are illustrated in a series, the process steps are not necessarily order dependent. Some steps may be done in a different order than that presented. Further, processes within the scope of this disclosure may include fewer or more steps than those illustrated in Figure 8. Initially, the bottom electrode 32 is formed, as shown in step 102. Next, the multilayer transduction structure 36 is formed over the bottom electrode 32, as shown in step 104. Herein, the multilayer transduction structure 36 includes the multiple transduction layers 38. At least one of the transduction layers 38 is formed of a ferroelectric material, whose polarization will vary with an electric field across the ferroelectric material. More details of the multilayer transduction structure 36 are the same as described above. The top electrode 34 is formed over the multilayer transduction structure 36 to provide the BAW resonator 30, as shown in step 106. As such, the multilayer transduction structure 36 is sandwiched between the bottom electrode 32 and the top electrode 34. Once the structure of the BAW resonator 30 is complete, a DC bias voltage can be applied across the bottom electrode 32 and the top electrode 34 to change the overall polarization of the multilayer transduction structure 36 and the overall electromechanical coupling coefficient of the multilayer transduction structure 36, as shown in step 108. Notice that once the change of the overall electromechanical coupling coefficient of the multilayer transduction structure 36 is completed, the overall electromechanical coupling coefficient of the multilayer transduction structure 36 will remain unchanged after removing the DC bias voltage.

Figure 9 illustrates a block diagram of an example system 900 that includes at least one BAW filter, which is implemented by one or more BAW resonators 30/30A/30B/30C as shown in Figures 3 and 5-7, respectively. The system 900 includes RF input circuitry 902 connected to filter circuitry 904. In certain embodiments, the RF input circuitry 902 includes a transceiver.

For the purpose of this illustration, the filter circuitry 904 includes three filters 906A, 906B, and 906C. Herein, one or more of the filters 906A, 906B, and 906C may be BAW filters, which are implemented by one or more BAW resonators 30/30A/30B/30C. In different applications, the filter circuitry 904 may include more or fewer filters. In one embodiment, each of the filters 906A, 906B, and 906C may be a lowpass filter or a bandpass filter, and the filters 906A, 906B, and 906C may be connected in a cascaded arrangement. The filter types that are included in the filter circuitry 904 may be based at least on the rejection requirements of the system 900.

The filter circuitry 904 is connected to an RF output circuitry 908. In certain embodiments, the RF output circuitry 908 includes an antenna. The RF input circuitry 902 and/or the RF output circuitry 908 may include additional or different components in other embodiments.

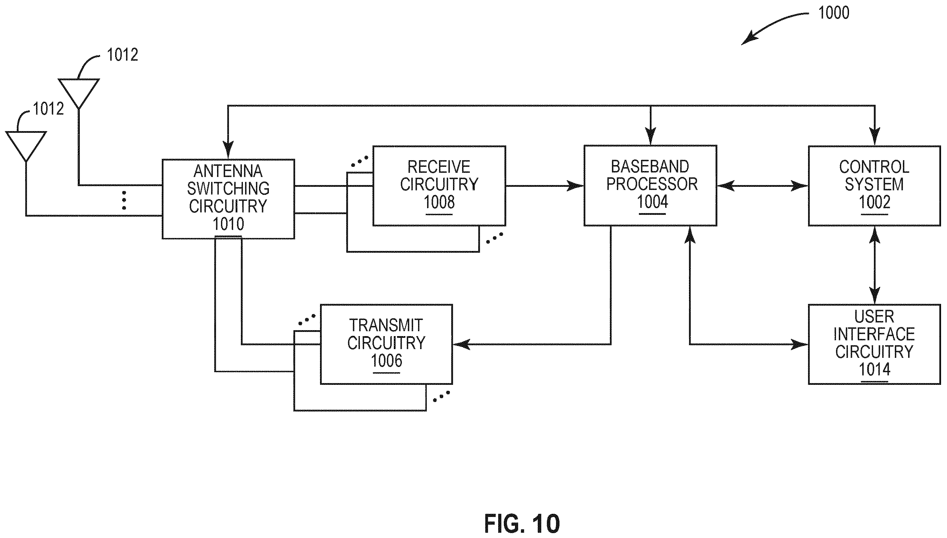

Figure 10 illustrates a block diagram of example user elements that include at least one BAW filter, which is implemented by one or more BAW resonators 30/30A/30B/30C shown in Figures 3 and 5-7, respectively. The concepts described above may be implemented in various types of user elements 1000, such as mobile terminals, smart watches, tablets, computers, navigation devices, access points, and like wireless communication devices that support wireless communications, such as cellular, wireless local area network (WLAN), BLUETOOTH, and near field communications. The user elements 1000 will generally include a control system 1002, a baseband processor 1004, transmit circuitry 1006, receive circuitry 1008, antenna switching circuitry 1010, multiple antennas 1012, and user interface circuitry 1014. In a non-limiting example, the control system 1002 can be a field-programmable gate array (FPGA) or an application-specific integrated circuit (ASIC), as an example. In this regard, the control system 1002 can include at least a microprocessor(s), an embedded memory circuit(s), and a communication bus interface(s). The receive circuitry 1008 receives radio frequency signals via the antennas 1012 and through the antenna switching circuitry 1010 from one or more base stations. A low noise amplifier and a filter of the receive circuitry 1008 cooperate to amplify and remove broadband interference from the received signal for processing. Down conversion and digitization circuitry (not shown) will then down convert the filtered, received signal to an intermediate or baseband frequency signal, which is then digitized into one or more digital streams using analog-to-digital converter(s) (ADC).

The baseband processor 1004 processes the digitized received signal to extract the information or data bits conveyed in the received signal. This processing typically comprises demodulation, decoding, and error correction operations, as will be discussed in greater detail below. The baseband processor 1004 is generally implemented in one or more digital signal processors (DSPs) and ASICs.

For transmission, the baseband processor 1004 receives digitized data, which may represent voice, data, or control information, from the control system 1002, which it encodes for transmission. The encoded data is output to the transmit circuitry 1006, where a digital-to-analog converter(s) (DAC) converts the digitally encoded data into an analog signal and a modulator modulates the analog signal onto a carrier signal that is at a desired transmit frequency or frequencies. A power amplifier will amplify the modulated carrier signal to a level appropriate for transmission and deliver the modulated carrier signal to the antennas 1012 through the antenna switching circuitry 1010 to the antennas 1012. The multiple antennas 1012 and the replicated transmit and receive circuitries 1006, 1008 may provide spatial diversity. Modulation and processing details will be understood by those skilled in the art.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

Therefore, from one perspective, there have been described approaches for a Bulk Acoustic Wave (BAW) resonator with tunable electromechanical coupling. The disclosed BAW resonator includes a bottom electrode, a top electrode, and a multilayer transduction structure sandwiched therebetween. Herein, the multilayer transduction structure is composed of multiple transduction layers, and at least one of the transduction layers is formed of a ferroelectric material, whose polarization will vary with an electric field across the ferroelectric material. Upon adjusting direct current (DC) bias voltage across the bottom electrode and the top electrode, an overall polarization of the multilayer transduction structure and an overall electromechanical coupling coefficient of the multilayer transduction structure are capable of being changed. Once the change of the overall electromechanical coupling coefficient of the multilayer transduction structure is completed, the overall electromechanical coupling coefficient of the multilayer transduction structure will remain unchanged after removing the DC bias voltage.

Further examples are set out in the following numbered clauses:
Clause 1. A Bulk Acoustic Wave, BAW, resonator with tunable electromechanical coupling, comprising: a bottom electrode; a top electrode; and a multilayer transduction structure sandwiched between the bottom electrode and the top electrode, wherein: the multilayer transduction structure is composed of a plurality of transduction layers; at least one of the plurality of transduction layers is formed of a first ferroelectric material, whose polarization will vary with an electric field across the ferroelectric material; and upon adjusting a direct current, DC, bias voltage across the bottom electrode and the top electrode, an overall polarization of the multilayer transduction structure and an overall electromechanical coupling coefficient of the multilayer transduction structure are capable of being changed.
Clause 2. The BAW resonator of clause 1 wherein once the change of the overall electromechanical coupling coefficient of the multilayer transduction structure is completed, the overall electromechanical coupling coefficient of the multilayer transduction structure will remain unchanged after removing the DC bias voltage.
Clause 3. The BAW resonator of clause 1 or 2 wherein the first ferroelectric material used to form the at least one of the plurality of transduction layers has a box-shaped polarization-electric field, P-E, curve.
Clause 4, The BAW resonator of clause 3 wherein the first ferroelectric material is scandium aluminum nitride ,ScxAl1-xN, and the P-E curve of ScₓAl₁₋ₓN is dependent on a scandium concentration x.
Clause 5. The BAW resonator of clause 4 wherein at least one of the plurality of transduction layers is formed of a second ferroelectric material, which has a different P-E curve compared to the first ferroelectric material.
Clause 6. The BAW resonator of clause 5 wherein at least one of the plurality of transduction layers is formed of a piezoelectric material, whose polarization does not vary with an electric field across the piezoelectric material.
Clause 7. The BAW resonator of any preceding clause wherein each of the plurality of transduction layers is formed of a different ferroelectric material.
Clause 8. The BAW resonator of any preceding clause wherein at least one of the plurality of transduction layers is formed of a piezoelectric material, whose polarization does not vary with an electric field across the piezoelectric material.
Clause 9. The BAW resonator of any preceding clause wherein each of the plurality of transduction layers has a different thickness.
Clause 10. The BAW resonator of any of clauses 1 to 8 wherein each of the plurality of transduction layers has a same thickness.
Clause 11. The BAW resonator of any preceding clause further comprising a bottom Brag reflector formed underneath the bottom electrode.
Clause 12. The BAW resonator of clause 11 further comprising a top Brag reflector formed over the top electrode.
Clause 13. The BAW resonator of any preceding clause wherein the multilayer transduction structure further comprises a plurality of internal electrodes, which are alternated with the plurality of transduction layers.
Clause 14. The BAW resonator of clause 13 wherein each of the plurality of transduction layers is formed of a different ferroelectric material.
Clause 15. A method of forming a Bulk Acoustic Wave, BAW, resonator with tunable electromechanical coupling, comprising: forming a bottom electrode; forming a multilayer transduction structure over the bottom electrode; and forming a top electrode over the multilayer transduction structure, such that the multilayer transduction structure is sandwiched between the bottom electrode and the top electrode, wherein: the multilayer transduction structure is composed of a plurality of transduction layers; at least one of the plurality of transduction layers is formed of a first ferroelectric material, whose polarization will vary with an electric field across the ferroelectric material; and upon adjusting a direct current (DC) bias voltage across the bottom electrode and the top electrode, an overall polarization of the multilayer transduction structure and an overall electromechanical coupling coefficient of the multilayer transduction structure are capable of being changed.
Clause 16. The method of clause 15 further comprising applying a DC bias voltage across the bottom electrode and the top electrode to change the overall polarization of the multilayer transduction structure and the overall electromechanical coupling coefficient of the multilayer transduction structure, wherein once the change of the overall electromechanical coupling coefficient of the multilayer transduction structure is completed, the overall electromechanical coupling coefficient of the multilayer transduction structure will remain unchanged after removing the DC bias voltage.
Clause 17. The method of clause 15 or 16 wherein the first ferroelectric material used to form the at least one of the plurality of transduction layers has a box-shaped polarization-electric field, P-E, curve.
Clause 18. The method of clause 17 wherein the first ferroelectric material is scandium aluminum nitride, ScxAl1-xN, and the P-E curve of ScₓAl₁₋ₓN is dependent on a scandium concentration x.
Clause 19. The method of clause 17 or 18 wherein at least one of the plurality of transduction layers is formed of a second ferroelectric material, which has a different P-E curve compared to the first ferroelectric material.
Clause 20. The method of any of clauses 15 to 19 wherein each of the plurality of transduction layers is formed of a different ferroelectric material.
Clause 21. The method of any of clauses 15 to 20 wherein at least one of the plurality of transduction layers is formed of a piezoelectric material, whose polarization does not vary with an electric field across the piezoelectric material.
Clause 22. A system, comprising: a radio-frequency (RF) input circuitry; a RF output circuitry; and a filter circuitry, which includes at least one Bulk Acoustic Wave (BAW) resonator, connected between the RF input circuitry and the RF output circuitry, wherein the at least one BAW resonator comprises: a bottom electrode; a top electrode; and a multilayer transduction structure sandwiched between the bottom electrode and the top electrode, wherein: the multilayer transduction structure is composed of a plurality of transduction layers; at least one of the plurality of transduction layers is formed of a first ferroelectric material, whose polarization will vary with an electric field across the ferroelectric material; and upon adjusting a direct current (DC) bias voltage across the bottom electrode and the top electrode, an overall polarization of the multilayer transduction structure and an overall electromechanical coupling coefficient of the multilayer transduction structure are capable of being changed.

## Claims

1. A Bulk Acoustic Wave, BAW, resonator with tunable electromechanical coupling, comprising:
a bottom electrode;
a top electrode; and
a multilayer transduction structure sandwiched between the bottom electrode and the top electrode, wherein:
the multilayer transduction structure is composed of a plurality of transduction layers;
at least one of the plurality of transduction layers is formed of a first ferroelectric material, whose polarization will vary with an electric field across the ferroelectric material; and
upon adjusting a direct current, DC, bias voltage across the bottom electrode and the top electrode, an overall polarization of the multilayer transduction structure and an overall electromechanical coupling coefficient of the multilayer transduction structure are capable of being changed.

2. The BAW resonator of claim 1 wherein once the change of the overall electromechanical coupling coefficient of the multilayer transduction structure is completed, the overall electromechanical coupling coefficient of the multilayer transduction structure will remain unchanged after removing the DC bias voltage.

3. The BAW resonator of claim 1 or 2 wherein the first ferroelectric material used to form the at least one of the plurality of transduction layers has a box-shaped polarization-electric field, P-E, curve.

4. The BAW resonator of claim 3 wherein the first ferroelectric material is scandium aluminum nitride ,ScₓAl₁₋ₓN, and the P-E curve of ScₓAl₁₋ₓN is dependent on a scandium concentration x.

5. The BAW resonator of claim 4 wherein at least one of the plurality of transduction layers is formed of a second ferroelectric material, which has a different P-E curve compared to the first ferroelectric material.

6. The BAW resonator of claim 4 or 5 wherein at least one of the plurality of transduction layers is formed of a piezoelectric material, whose polarization does not vary with an electric field across the piezoelectric material.

7. The BAW resonator of any preceding claim wherein each of the plurality of transduction layers is formed of a different ferroelectric material.

8. The BAW resonator of any preceding claim wherein at least one of the plurality of transduction layers is formed of a piezoelectric material, whose polarization does not vary with an electric field across the piezoelectric material.

9. The BAW resonator of any preceding claim wherein each of the plurality of transduction layers has a thickness selected from the group comprising: a different thickness; and a same thickness.

10. The BAW resonator of any preceding claim further comprising a bottom Brag reflector formed underneath the bottom electrode, and for example further comprising a top Brag reflector formed over the top electrode.

11. The BAW resonator of any preceding claim wherein the multilayer transduction structure further comprises a plurality of internal electrodes, which are alternated with the plurality of transduction layers.

12. A system, comprising:
a radio-frequency (RF) input circuitry;
a RF output circuitry; and
a filter circuitry, which includes at least one Bulk Acoustic Wave (BAW) resonator according to any preceding claim, connected between the RF input circuitry and the RF output circuitry.

13. A method of forming a Bulk Acoustic Wave, BAW, resonator with tunable electromechanical coupling, comprising:
forming a bottom electrode;
forming a multilayer transduction structure over the bottom electrode; and
forming a top electrode over the multilayer transduction structure, such that the multilayer transduction structure is sandwiched between the bottom electrode and the top electrode, wherein:
the multilayer transduction structure is composed of a plurality of transduction layers;
at least one of the plurality of transduction layers is formed of a first ferroelectric material, whose polarization will vary with an electric field across the ferroelectric material; and
upon adjusting a direct current (DC) bias voltage across the bottom electrode and the top electrode, an overall polarization of the multilayer transduction structure and an overall electromechanical coupling coefficient of the multilayer transduction structure are capable of being changed.

14. The method of claim 13 further comprising applying a DC bias voltage across the bottom electrode and the top electrode to change the overall polarization of the multilayer transduction structure and the overall electromechanical coupling coefficient of the multilayer transduction structure, wherein once the change of the overall electromechanical coupling coefficient of the multilayer transduction structure is completed, the overall electromechanical coupling coefficient of the multilayer transduction structure will remain unchanged after removing the DC bias voltage.

15. The method of claim 13 or 14 further comprising performing forming the BAW resonator to have the functionality defined in any of claims 2 to 11.
